# EUROPEAN PATENT SPECIFICATION

(11) **EP 4 257 818 B1**
(45) Date of publication and mention of the grant of the patent: **28.01.2026**
(21) Application number: 21899686.6
(22) Date of filing: 23.09.2021
(51) Int. Cl.: F02K 9/96, G06F 30/15, G06F 30/17, G01B 11/00, G01C 15/00, F02K 9/42, G01B 11/26, G06F 30/20

(54) **METHOD FOR PREDICTING STRUCTURAL RESPONSE OF LIQUID-PROPELLANT ROCKET ENGINE TO IMPACT LOAD**
VERFAHREN ZUR VORHERSAGE DER STRUKTURELLEN REAKTION EINES FLÜSSIGKEITSRAKETENMOTORS AUF EINE STOSSBELASTUNG
PROCÉDÉ DE PRÉDICTION DE RÉPONSE STRUCTURALE DE MOTEUR-FUSÉE À PROPERGOL LIQUIDE À UNE CHARGE D'IMPACT

(30) Priority: 02.12.2020 CN 202011400048; 02.12.2020 CN 202011400057
(43) Date of publication of application: 11.10.2023
(73) Proprietor: Xi'an Aerospace Propulsion Institute, Shaanxi 710100 (CN)
(72) Inventor: LI, Bin, Xi'an, Shaanxi 710100 (CN); CHEN, Hui, Xi'an, Shaanxi 710100 (CN); WANG, Chunmin, Xi'an, Shaanxi 710100 (CN); GAO, Yushan, Xi'an, Shaanxi 710100 (CN); YANG, Sa, Xi'an, Shaanxi 710100 (CN); WANG, Meng, Xi'an, Shaanxi 710100 (CN); LI, Binchao, Xi'an, Shaanxi 710100 (CN); XING, Lixiang, Xi'an, Shaanxi 710100 (CN); HAN, Shuai, Xi'an, Shaanxi 710100 (CN)
(74) Representative: Casalonga
(86) International application number: PCT/CN2021/119739
(87) International publication number: WO 2022/116652

(56) References cited:
- CN-A- 101 603 812
- CN-A- 103 616 151
- CN-A- 106 595 654
- CN-A- 108 225 258
- CN-A- 109 271 660
- CN-A- 109 798 204
- CN-A- 112 504 121
- CN-A- 112 555 055
- JP-A- H07 277 295
- ASRAFF A K ET AL: "Comparison of Creep Properties of Four Copper Alloys and Creep Based Stress Analysis of a Rocket Engine Combustion Chamber", PROCEDIA ENGINEERING, ELSEVIER BV, NL, vol. 55, 22 April 2013 (2013-04-22), pages 45 - 50, XP028584317, DOI: 10.1016/J.PROENG.2013.03.217
- GLIGORIJEVIC NIKOLA ET AL: "Thermal and Acceleration Load Analysis of New 122 mm Rocket Propellant Grain", 31 December 2016 (2016-12-31), XP093209247, Retrieved from the Internet <URL:https://www.researchgate.net/publication/319191263_Thermal_and_acceleration_load_analysis_of_new_122_mm_rocket_propellant_grain> [retrieved on 20240926]
- LAL SANTHINI S ET AL: "Thermostructural Analysis of Rocket Engine Thrust Chamber", 31 August 2015 (2015-08-31), XP093209248, Retrieved from the Internet <URL:https://www.ijert.org/research/thermostructural-analysis-of-rocket-engine-thrust-chamber-IJERTV4IS080439.pdf> [retrieved on 20240926]
- ASRAFF AHMEDUL KABIR ET AL: "Application of Chaboche Model in Rocket Thrust Chamber Analysis", JOURNAL OF THE INSTITUTION OF ENGINEERS (INDIA): SERIES C, SPRINGER INDIA, INDIA, vol. 98, no. 3, 12 December 2015 (2015-12-12), pages 227 - 233, XP036231636, ISSN: 2250-0545, [retrieved on 20151212], DOI: 10.1007/S40032-015-0209-6
- RENITHA P ET AL: "Design analysis and optimization of Thrust Measurement System for testing semi-cryogenic rocket engine", 2016 INTERNATIONAL CONFERENCE ON ENERGY EFFICIENT TECHNOLOGIES FOR SUSTAINABILITY (ICEETS), IEEE, 7 April 2016 (2016-04-07), pages 912 - 916, XP032975026, ISBN: 978-1-5090-1534-4, [retrieved on 20161005], DOI: 10.1109/ICEETS.2016.7583878
- YINGYING YE: "Analysis of Structure Vibration Characteristics of a New Type of Engine", MASTER THESIS, CHINA ACADEMY OF LAUNCH VEHICLE TECHNOLOGY, CN, 30 June 2019 (2019-06-30), CN, pages 1 - 134, XP055937103, [retrieved on 20220630]

## Description

### Cross-Reference to Related Application

The present disclosure claims the priority of Chinese Patent Application No. 202011400048.3, and 202011400057.2 both filed to the China National Intellectual Property Administration on February 2, 2020 and entitled "Liquid Rocket Engine Impact Load Structural Response Prediction Method'.

### Technical Field

The present invention relates to a liquid rocket engine, in particular to a liquid rocket engine impact load structural response prediction method.

### Background

In the process of hot test run, a structure of a liquid rocket engine will shake violently. There are many reasons for shaking, such as water shock during valve opening and closing, vibration caused by intense combustion in a combustion chamber and vibration caused by a harsh working environment in a turbo pump. A violent shaking process may cause damage to structural strength of the engine under a current working condition or even a higher working condition. Therefore, it is necessary to study an engine impact load structural response prediction method. In the process of hot test run, it is difficult to identify and collect a load source, and there will be complex coupling between each other, which makes great difficulty to obtain an excitation load in the process of engine impact dynamics research. Input loads adopted in a conventional impact dynamics research process are all single acceleration loads which difficultly satisfy a multi-source load excitation condition in the complex process of hot test run. Therefore, it is necessary to develop a rocket engine impact load structural response prediction method, which may carry out the multi-source load impact dynamics research in a complete-machine state under the condition of not using the acceleration loads as load excitation, so as to realize analysis and evaluation of the structural strength of key parts of the engine and rocking bearings. Document XP028584317 represents relevant prior art.

### Summary

The invention is defined by the claims.

The present invention aims to provide a liquid rocket engine impact load structural response prediction method in order to solve the technical problem that input loads adopted in an existing liquid rocket engine impact load structural response prediction method are all single acceleration loads, and a multi-source load excitation condition in a complex process of hot test run is difficult to meet.

To solve the above technical problem, a technical solution provided by the present invention is as follows:
a liquid rocket engine impact load structural response prediction method, characterized by including the following steps:
1) simplifying an engine complete-machine model
   obtaining a simplified engine complete-machine model by simplifying a frame of an engine to be of a beam structure, simplifying to-be-detected parts of the engine to be of housing structures, adopting a solid structure for a gas elbow of the engine, and ignoring each fine pipeline of the engine, the simplified engine complete-machine model including the frame, the gas elbow and a turbopump sequentially connected from top to bottom, a middle part of the gas elbow being connected with the frame, two ends of the gas elbow being hinged with cantilevers through rocking bearings respectively, and spray pipes being arranged at tail ends of the two cantilevers respectively;
2) constructing an engine structural dynamics simulation model
   modeling the simplified engine complete-machine model to obtain the engine structural dynamics simulation model, and connecting a frame part of the simulation model with a test bed moving support simulation model;
3) loading an impact load
   performing high-speed photography in a real engine test run process, and processing image data obtained from the photography to obtain position and pose change data of the to-be-detected parts, the position and pose change data being a time-varying curve of displacement, and the curve including data of three directions: an axial direction, a radial direction and a tangential direction; and taking the position and pose change data as the impact load to be loaded into corresponding positions of the simulation model;
4) performing engine impact structural dynamics solving
   after step 3) is completed, performing engine simulation model impact structural dynamics solving; and
5) analyzing a solving result
   by using the solving result obtained in step 4), analyzing structural strength of the to-be-detected parts of the engine and rocking angle characteristics of the rocking bearings at hinge positions, and effectively evaluating a structural strength security domain degree during standard working-condition and high-working-condition test run of the engine according to an analysis result.

Furthermore, in step 5), analyzing the structural strength of the to-be-detected parts of the engine and the rocking angle characteristics of the rocking bearings at the hinge positions includes the following specific steps:
extracting a time-varying curve of the structural strength of the to-be-detected parts of the engine from the simulation model, analyzing a magnitude of maximum structural strength and an influence of an appearing moment of the maximum structural strength on an engine structure, extracting a time-varying curve of rocking angles of the rocking bearings, and analyzing sizes of maximum rocking angles and an influence of an appearing moment of the maximum rocking angles on the rocking bearings.

Furthermore, during modeling in step 1), mass of a corresponding component in the simulation model is corrected according to actual mass of each component of the engine, to make the mass of the corresponding component in the simulation model the same as the mass of each component of the engine.

Furthermore, in step 1), the to-be-detected parts include the turbopump and the two spray pipes.

Furthermore, when engine impact structural dynamics solving is performed in step 4), a set duration is added to an output result.

Furthermore, in step 4), the set duration is 1 s.

Furthermore, step 3) is realized based on a high-thrust rocket engine structural attitude monitoring system, and the high-thrust rocket engine structural attitude monitoring system includes reflective mark points, reflective target balls, inertial sensors, laser trackers, a control collector and at least two high-speed cameras;
the inertial sensors are arranged at a butting end of a to-be-detected engine and a test bed butting support and configured to measure moving speed and displacement information of the butting end of the to-be-detected engine;
the reflective mark points are arranged on to-be-detected parts of the to-be-detected engine and configured to perform position identification;
the at least two high-speed cameras are both arranged around the to-be-detected engine and configured to form a three-dimensional spatial vision measurement domain of the to-be-detected engine;
the reflective target balls are arranged on the to-be-detected engine and located in the vision measurement domain of the high-speed cameras;
the laser trackers are arranged at a position away from a test bed and configured to track a three-dimensional dynamic trajectory of the reflective target balls in real time;
an input end of the control collector is connected with output ends of the inertial sensors, the laser trackers and the high-speed cameras at the same time; and
step 3) specifically includes the following steps:
   3.1) butting the to-be-detected engine to the test bed, simultaneously triggering the high-speed cameras, the laser trackers and the inertial sensors through test run time unification of a test run control measurement system, and collecting, by the control collector, image data of a whole test run process, the three-dimensional dynamic trajectory of the reflective target balls and the moving speed and displacement information of the butting end of the engine according to the same frequency;
   3.2) performing detection of the reflective mark points and detection of the reflective target balls on the image data obtained in step 3.1) frame by frame, and forming engine position and pose information containing own additional displacement of the high-speed cameras and displacement of the test bed butting support according to a time sequence;
   3.3) by using the three-dimensional dynamic trajectory of the reflective target balls obtained in step 3.1), performing frame-by-frame comparison on position and pose information of the reflective target balls in the engine position and pose information obtained in step 3.2), so as to obtain the additional displacement of the high-speed cameras in frame-by-frame image data, and using the additional displacement for performing compensational correction on the engine position and pose information obtained in step 3.2); and
   3.4) according to the moving speed and displacement information of the butting end of the engine obtained in step 3.1), correcting a result obtained in step 3.3), so as to obtain position and pose change data of the engine relative to the butting support for engine impact load structural response evaluation.

Furthermore, the position and pose change data in step 3.4) is a time-varying curve of displacement, and the curve includes data of three directions: an axial direction X, a radial direction Y and a tangential direction Z.

Furthermore, a plurality of reflective target balls are provided, and at least one reflective target ball is located in the vision measurement domain of the high-speed cameras.

Furthermore, the to-be-detected parts are the turbopump and the two spray pipes of the to-be-detected engine, two high-speed cameras are provided, frame rates are both 1000 frames/s, and a plurality of inertial sensors are provided.

The liquid rocket engine impact load structural response prediction method provided by the present invention integrates a liquid rocket engine complete-machine structural dynamics modeling technology and a multi-excitation-source impact dynamics analysis method, on the basis of reasonable simplification of the liquid rocket engine complete-machine model, the dilemma that an existing method adopts single acceleration load excitation is overcome, in the case that an effective acceleration load cannot be obtained, forced displacement loads are applied to a plurality of positions as excitation inputs to carry out liquid rocket engine complete-machine structural dynamics analysis, and structural strength of key parts of the engine and the rocking angles of the rocking bearings are analyzed, so that the shortcomings of harsh technical conditions, a limited range, difficult identification of acceleration excitation sources and single load excitation in the prior art are overcome, an effective evaluation of engine structural optimization and ultimate bearing capacity may be provided, and then effective prediction of engine structural strength in the subsequent high-working-condition test run is provided.

The liquid rocket engine impact load structural response prediction method provided by the present invention, compared with traditional structural dynamics simulation modeling, does not need an acceleration load as a load input condition, and adopts a forced displacement curve (position and pose change data) as a load input condition, solving the problem that the acceleration load excitation cannot be accurately obtained during the engine hot test run.

The liquid rocket engine impact load structural response prediction method provided by the present invention, compared with traditional structural dynamics simulation solving, may apply the load excitation to a plurality of positions of the engine at the same time, and more truly simulate an actual working state of the engine, and a result obtained through solving provides a more real reference for the strength analysis of a key position of the engine and provides more powerful technical support for predicting structural strength of the engine under high-working-condition test run.

The frame of the engine is simplified to be of the beam structure, the to-be-detected parts of the engine are simplified to be of the housing structures, and the gas elbow of the engine adopts the solid structure, and each fine pipeline of the engine is ignored, so that the simplified engine complete-machine model is obtained, and only the key components of the engine are retained, facilitating construction of the engine structural dynamics simulation model.

Considering that an engine structural dynamic response under the impact load will be delayed, when engine impact structural dynamics solving is performed, the set duration is added to an output result, so that the solving result is closer to a real working condition.

In the prediction method of the present invention, impact load loading is realized based on the high-thrust rocket engine structural attitude monitoring system, and in combination with multi-technology integration of high-speed photographic vision measurement, laser tracking measurement and inertial sensor measurement, the method is the structural response measurement technology of power apparatus hot test run. Two or more high-speed cameras are used to form the three-dimensional visual measurement domain to measure the structural displacement of the high-thrust rocket engine in the whole field. Through inertial navigation measurement and a laser tracking technology, the additional displacement caused by vibration of the high-speed cameras and the test bed is compensated, so that the shortcomings of limited measurement points of traditional vibration and strain sensors and large deviation of a digital image correlation technology in strong vibration environments are overcome, the position and pose change of each part of the engine relative to the butting end of the engine is obtained, the position and pose (engine structural vibration displacement) measurement of the high-thrust rocket engine hot test run strong vibration and shock environment may be achieved, and the engine hot-state test run whole structural response may be accurately obtained; and measured structural displacement data may be used for evaluating engine performance, and meanwhile may also be directly used for structural response simulation analysis and checking in the engine hot test run process, so as to predict structural reliability of the engine.

Data of the laser trackers are used to compensate the position and pose data of high-speed photography solving, the additional displacement caused by strong vibration such as deflection of the high-speed cameras may be compensated, more accurate position and pose data may be obtained, and the difficulty in the design of fixed vibration reduction of the high-speed cameras may be reduced.

Due to a compact layout and a complex structure of the high-thrust engine, there is a measurement dead zone in the measurement space formed by the high-speed cameras, the laser trackers and the inertial sensors can be used to supplement and measure structural position and pose information of the dead zone position, and three-dimensional holographic position and pose data are obtained.

The relative position and pose data of the engine relative to the test bed butting support may be calculated by measuring the position and pose information of the butting end of the engine through the inertial sensors, and the data may be directly applied to the engine structural response simulation based on the position and pose change.

### Brief Description of the Drawings

In order to more clearly illustrate the technical solutions in the embodiments of the present disclosure or the technical solutions in the related art, the drawings used in the related technical description of the embodiments will be briefly described below. It is apparent that the drawings in the following descriptions are merely the embodiments of the present disclosure. Other drawings may be obtained from those of ordinary skill in the art according to the drawings without any creative work.
Fig. 1 is a flow diagram of a liquid rocket engine impact load structural response prediction method of the present invention;
Fig. 2 is a schematic structural diagram of a simplified engine complete-machine model obtained in step 1 of a liquid rocket engine impact load structural response prediction method of the present invention;
Fig. 3 is a time-varying curve of displacement as an impact load in step 3 in an embodiment of the present invention;
Fig. 4 is a time-varying curve of structural strength in step 5 in an embodiment of the present invention, which only shows a curve corresponding to a shutdown stage;
Fig. 5 is a time-varying curve of rocking angles of rocking bearings in step 5 in an embodiment of the present invention;
Fig. 6 is a structural schematic diagram of a high-thrust rocket engine structural attitude monitoring system in an embodiment of the present invention; and

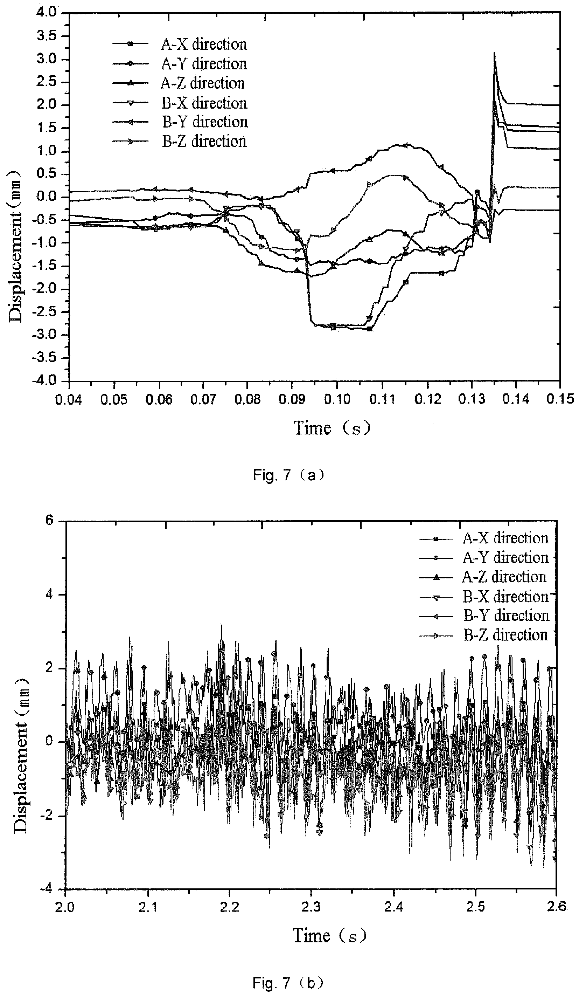

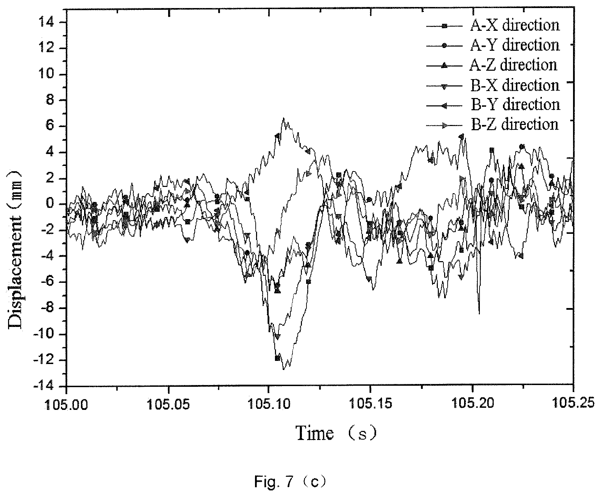

Fig. 7 is a position and pose change data diagram of to-be-detected parts of an engine in different stages analyzed by adopting a high-thrust rocket engine structural attitude monitoring system in an embodiment of the present invention, wherein Fig. 7 (a) is a starting stage, Fig. 7 (b) is a main level stage, Fig. 7 (c) is a shutdown stage, in all figures, A is a first to-be-detected part, B is a second to-be-detected part, position and pose change data are a time-varying curve of displacement, and the curve includes data of three directions: an axial direction X, a radial direction Y and a tangential direction Z.

Reference signs are illustrated as:
01-butting support, 02-reflective mark point, 03-reflective target ball, 04-inertial sensor, 05-laser tracker, 06- high-speed camera, 07-to-be-detected engine, 08-control collector, 1-frame, 2-rocking bearing, 3-turbopump, 4-spray pipe, and 5-gas elbow.

### Detailed Description of the Embodiments

The present invention is further explained in combination with the accompanying drawings and embodiments below. The contents not described in detail in the specification of the present invention belong to the public art of those skilled in the art.

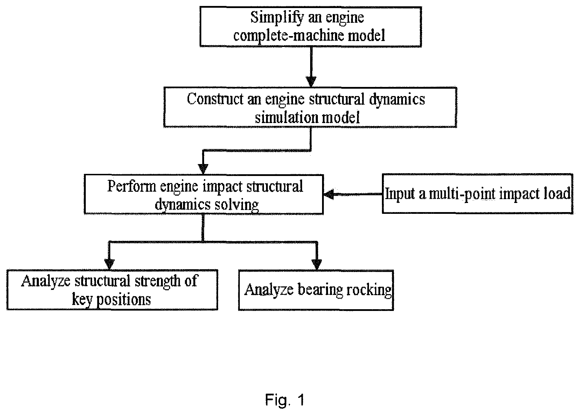

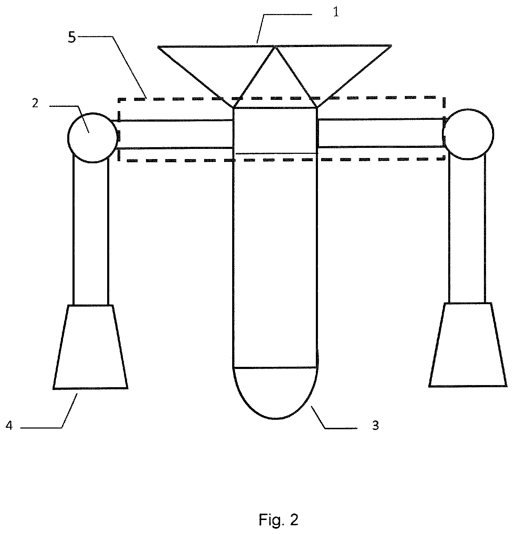

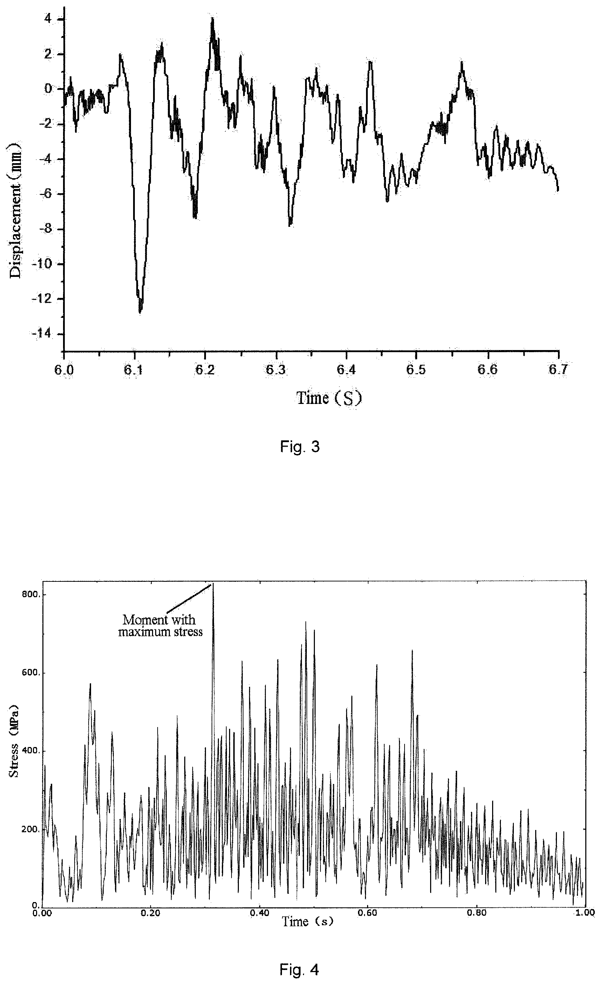

A liquid rocket engine impact load structural response prediction method builds an engine complete-machine dynamics model and multi-source load excitation loading, so as to perform engine impact load structural strength analysis, and structural strength of key parts of an engine and rocking angles of bearings are checked. As shown in Fig. 1, the method includes the following steps:
1) simplifying an engine complete-machine model, wherein
   according to engine complete-machine structural characteristics and a calculation requirement, an engine complete machine is structurally simplified. A frame 1 of an engine is simplified to be of a beam structure, to-be-detected parts (key components, such as a turbopump 3 and two spray pipes 4) of the engine are simplified to be of housing structures, a gas elbow 5 of the engine adopts a solid structure, and each fine pipeline of the engine is ignored, so that a simplified engine complete-machine model is obtained. As shown in Fig. 2, the simplified engine complete-machine model includes the frame 1, the gas elbow 5 and the turbopump 3 sequentially connected from top to bottom, a middle part of the gas elbow 5 is connected with the frame 1, two ends of the gas elbow 5 are hinged with cantilevers through rocking bearings 2 respectively, and tail ends of the two cantilevers are provided with the spray pipes 4 respectively;
2) constructing an engine structural dynamics simulation model, wherein
   the simplified engine complete-machine model is modeled to obtain the engine structural dynamics simulation model, mass of a corresponding component in the simulation model is corrected according to actual mass of each component of the engine, to enable the mass of each component of the engine to be the same as that of the corresponding component in the simulation model, and the frame 1 part of the simulation model is connected with a test bed moving support simulation model;
3) loading (inputting) a multi-point impact load, wherein
   high-speed photography is performed in the process of real engine test run, image data obtained from the photography are processed to obtain position and pose change data of the to-be-detected parts, as shown in Fig. 3, the position and pose change data are a time-varying curve of displacement, and the curve includes data of three directions: an axial direction, a radial direction and a tangential direction; the position and pose change data are taken as the impact load (forced displacement load) to be loaded into corresponding positions of the simulation model; three to-be-detected parts are farthest ends of free ends of the engine, and in the hot test run process, a rocking amplitude is maximum, may cover rocking displacement regions of remaining positions of the engine, and covers all delivery paths of the engine;
4) performing engine impact structural dynamics solving, wherein
   after step 3) is completed, engine simulation model impact structural dynamics solving is performed; considering that the structural dynamic response of the engine under the impact load effect will be delayed, 1 s is increased for an output result during engine impact structural dynamics solving; and
5) analyzing a solving result, wherein
   the solving result obtained in step 4) is used to analyze structural strength of the to-be-detected parts of the engine and rocking angle characteristics of the rocking bearings 2 at hinge positions, a structural strength security domain degree is effectively evaluated during standard-working-condition and high-working-condition test run of the engine according to an analysis result, and a corresponding structural parameter of the engine is optimized.

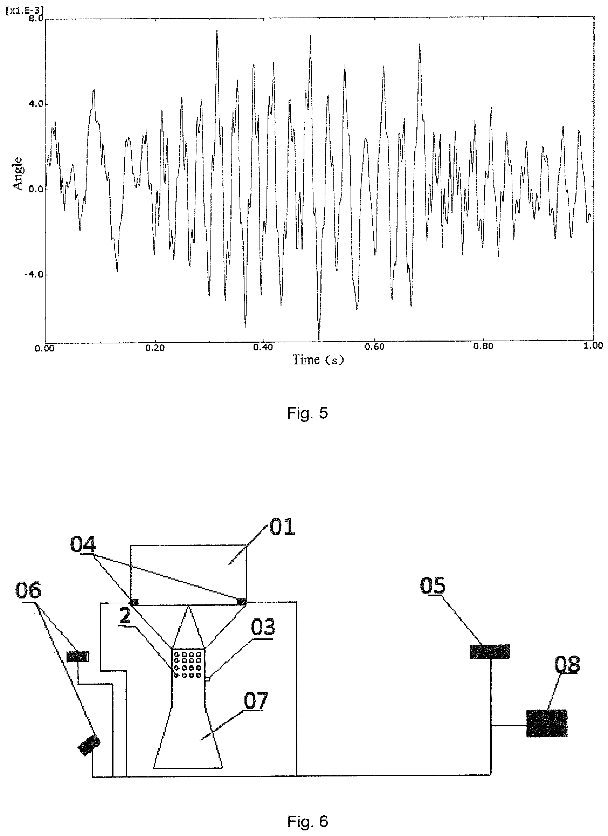

In step 5), analyzing the structural strength of the to-be-detected parts of the engine and the rocking angle characteristics of the rocking bearings at the hinge positions includes the following specific steps:
extracting a time-varying curve of the structural strength of the to-be-detected parts of the engine from the simulation model, analyzing a magnitude of maximum structural strength and an influence of an appearing moment of the maximum structural strength on an engine structure, extracting a time-varying curve of rocking angles of the rocking bearings 2, and analyzing sizes of maximum rocking angles and an influence of an appearing moment of the maximum rocking angles on the rocking bearings 2. Fig. 4 is a time-varying curve of the structural strength, which only shows a curve corresponding to a shutdown stage, and Fig. 5 is a time-varying curve of the rocking angles of the rocking bearings 2.

Step 3 may be realized based on a high-thrust rocket engine structural attitude monitoring system, as shown in Fig. 6, the high-thrust rocket engine structural attitude monitoring system includes a plurality of reflective mark points 02, a plurality of reflective target balls 03, a plurality of inertial sensors 04, a plurality of laser trackers 05, a control collector 08 and two high-speed cameras 06 at 1000 frames/s; the inertial sensors 04 are arranged at the butting end of the to-be-detected engine 07 and the test bed butting support 01, the engine, the test bed and the test bed butting support are all detected targets, and the sensors are configured to measure the moving speed and displacement information of the butting end of the to-be-detected engine 07; the plurality of reflective mark points 02 are arranged on the to-be-detected parts (the key parts of the engine, such as the turbopump and the two spray pipes) of the to-be-detected engine 07 and configured to distinguish positions; the plurality of high-speed cameras 06 are all arranged around the to-be-detected engine 07 and form a three-dimensional spatial vision measurement domain of the to-be-detected engine 07 through pre-test calibration; the plurality of reflective target balls 03 are arranged on the to-be-detected engine 07, and at least one reflective target ball 03 is located in the vision measurement domain of the high-speed cameras 06; the laser trackers 05 are reliably and fixedly arranged at a position away from the test bed (away from the engine), are free of the influence of test bed vibration, and are configured to track a three-dimensional dynamic trajectory of the reflective target balls in real time; and an input end of the control collector 08 is connected with output ends of the inertial sensors 04, the laser trackers 05 and the high-speed cameras 06 at the same time.

Step 3) is realized specifically through the following steps:
3.1) butting the to-be-detected engine 07 to the test bed, simultaneously triggering the high-speed cameras 06, the laser trackers 05 and the inertial sensors 04 through the test run time unification of the test run control measurement system, and collecting, by the control collector 08, image data of the whole test run process, the three-dimensional dynamic trajectory of the reflective target balls 03 and the moving speed and displacement information of the butting end of the engine according to the same frequency, to obtain position and pose analysis original data;
3.2) performing detection of the reflective mark points 02 and detection of the reflective target balls 03 on the image data obtained in step 3.1) frame by frame, and forming engine position and pose information containing own additional displacement of the high-speed cameras 06 and displacement of the test bed butting support 01 according to a time sequence;
3.3) by using the three-dimensional dynamic trajectory of the reflective target balls 03 obtained in step 3.1), performing frame-by-frame comparison on the position and pose information of the reflective target balls 03 in the engine position and pose information obtained in 3.2), so as to obtain the additional displacement of the high-speed cameras 06 in frame-by-frame image data, and using the additional displacement for performing compensational correction on the engine position and pose information obtained in step 3.2); and
3.4) according to the moving speed and displacement information of the butting end of the engine obtained in step 3.1), correcting a result obtained in step 3.3), so as to obtain position and pose change data of the engine relative to the butting support 01, wherein the position and pose change data are the time-varying curve of the displacement, and the curve contains data of three directions: the axial direction X, the radial direction Y and the tangential direction Z and is used for engine impact load structural response evaluation.

In the whole-process position and pose data of a key structure of an engine main structure obtained through above processing, the engine position and pose changes in the start stage, the main level stage and the shutdown stage, are shown in Fig. 7 (a), Fig 7 (b) and Fig. 7 (c) respectively, and are consistent with the working characteristics of the engine, that is, the data obtained in the analysis process can verify whether the working characteristics of the engine meet the requirements, and the position and pose change data of the engine relative to the butting support 01 obtained in step 3.4) can be used as load inputs for engine impact load structural response evaluation (prediction).

Finally, it should be noted that: the above embodiments are used only to illustrate the technical solution of the present invention, but not to restrict it. For those ordinarily skilled in the art, the specific technical solution recorded in the above embodiments may be modified or some of the technical features therein may be substituted equivalently, and such modifications or substitutions shall not make the essence of the corresponding technical solution depart from the scope of the technical solution protected by the present invention.

## Claims

1. A liquid rocket engine impact load structural response prediction method, the method comprising the following steps:
1) simplifying an engine complete-machine model
obtaining a simplified engine complete-machine model by simplifying a frame (1) of an engine to be of a beam structure, simplifying to-be-detected parts of the engine to be of housing structures, adopting a solid structure for a gas elbow (5) of the engine, and ignoring each fine pipeline of the engine, the simplified engine complete-machine model comprising the frame (1), the gas elbow (5) and a turbo pump (3) sequentially connected from top to bottom, a middle part of the gas elbow (5) being connected with the frame (1), two ends of the gas elbow (5) being hinged with cantilevers through rocking bearings (2) respectively, and spray pipes (4) being arranged at tail ends of the two cantilevers respectively;
2) constructing an engine structural dynamics simulation model
modeling the simplified engine complete-machine model to obtain the engine structural dynamics simulation model, and connecting the frame (1) part of the simulation model with a test bed moving support simulation model;
3) loading an impact load
performing high-speed photography in a real engine test run process, and processing image data obtained from the photography to obtain position and pose change data of the to-be-detected parts, the position and the pose change data being a time-varying curve of displacement, and the curve comprising data of three directions: an axial direction, a radial direction and a tangential direction; and taking the position and pose change data as the impact load to be loaded into corresponding positions of the simulation model;
4) performing engine impact structural dynamics solving
after step 3) is completed, performing engine simulation model impact structural dynamics solving; and
5) analyzing a solving result
by using a solving result obtained in step 4), analyzing structural strength of the to-be-detected parts of the engine and rocking angle characteristics of the rocking bearings (2) at hinge positions, and effectively evaluating a structural strength security domain degree during standard working-condition and high-working-condition test run of the engine according to an analysis result.

2. The liquid rocket engine impact load structural response prediction method according to claim 1, **characterized in that** in step 5), analyzing the structural strength of the to-be-detected parts of the engine and the rocking angle characteristics of the rocking bearings (2) at the hinge positions comprises the following specific steps:
extracting a time-varying curve of the structural strength of the to-be-detected parts of the engine from the simulation model, analyzing a magnitude of maximum structural strength and an influence of an appearing moment of the maximum structural strength on an engine structure, extracting a time-varying curve of rocking angles of the rocking bearings (2), and analyzing sizes of maximum rocking angles and an influence of an appearing moment of the maximum rocking angles on the rocking bearings (2).

3. The liquid rocket engine impact load structural response prediction method according to claim 1 or 2, **characterized in that** during modeling in step 1), mass of a corresponding component in the simulation model is corrected according to actual mass of each component of the engine, to make the mass of the corresponding component in the simulation model the same as the mass of each component of the engine.

4. The liquid rocket engine impact load structural response prediction method according to claim 3, **characterized in that** in step 1), the to-be-detected parts comprise the turbopump (3) and the two spray pipes (4).

5. The liquid rocket engine impact load structural response prediction method according to claim 4, **characterized in that** when engine impact structural dynamics solving is performed in step 4), a set duration is added to an output result.

6. The liquid rocket engine impact load structural response prediction method according to claim 5, **characterized in that** in step 4), the set duration is 1 s.

7. The liquid rocket engine impact load structural response prediction method according to any one of claims 1 to 6, **characterized in that** step 3) is realized based on a high-thrust rocket engine structural attitude monitoring system, and the high-thrust rocket engine structural attitude monitoring system comprises reflective mark points (02), reflective target balls (03), inertial sensors (04), laser trackers (05), a control collector (08) and at least two high-speed cameras (06);
the inertial sensors (04) are arranged at a butting end of a to-be-detected engine (07) and a test bed butting support (01) and configured to measure moving speed and displacement information of the butting end of the to-be-detected engine (07);
the reflective mark points (02) are arranged on to-be-detected parts of the to-be-detected engine (07), and configured to perform position identification;
the at least two high-speed cameras (06) are both arranged around the to-be-detected engine (07) and configured to form a three-dimensional spatial vision measurement domain of the to-be-detected engine (07);
the reflective target balls (03) are arranged on the to-be-detected engine (07) and located in the vision measurement domain of the high-speed cameras (06);
the laser trackers (05) are arranged at a position away from a test bed and configured to track a three-dimensional dynamic trajectory of the reflective target balls (03) in real time;
an input end of the control collector (08) is connected with output ends of the inertial sensors (04), the laser trackers (05) and the high-speed cameras (06) at the same time; and
step 3) specifically comprises the following steps:
3.1) butting the to-be-detected engine (07) to the test bed, simultaneously triggering the high-speed cameras (06), the laser trackers (05) and the inertial sensors (04) through test run time unification of a test run control measurement system, and collecting, by the control collector (08), image data of a whole test run process, the three-dimensional dynamic trajectory of the reflective target balls (03) and the moving speed and displacement information of the butting end of the engine according to the same frequency;
3.2) performing detection of the reflective mark points (02) and detection of the reflective target balls (03) on the image data obtained in step 3.1) frame by frame, and forming engine position and pose information containing own additional displacement of the high-speed cameras (06) and displacement of the test bed butting support (01) according to a time sequence;
3.3) by using the three-dimensional dynamic trajectory of the reflective target balls (03) obtained in step 3.1), performing frame-by-frame comparison on position and pose information of the reflective target balls (03) in the engine position and pose information obtained in 3.2), so as to obtain the additional displacement of the high-speed cameras (06) in frame-by-frame image data, and using the additional displacement for performing compensational correction on the engine position and pose information obtained in step 3.2); and
3.4) correcting a result obtained in step 3.3) according to the moving speed and displacement information of the butting end of the engine obtained in step 3.1), so as to obtain position and pose change data of the engine relative to the butting support (1) for engine impact load structural response evaluation.

8. The liquid rocket engine impact load structural response prediction method according to claim 7, **characterized in that** the position and pose change data in step 3.4) are a time-varying curve of displacement, and the curve comprises data of three directions: an axial direction X, a radial direction Y and a tangential direction Z.

9. The liquid rocket engine impact load structural response prediction method according to claim 8, **characterized in that** a plurality of reflective target balls (03) are provided, and at least one reflective target ball (03) is located in the vision measurement domain of the high-speed cameras (6).

10. The liquid rocket engine impact load structural response prediction method according to claim 9, **characterized in that** the to-be-detected parts are the turbo pump and the two spray pipes of the to-be-detected engine (07), two high-speed cameras (6) are provided, frame rates are both 1000 frames/s, and a plurality of inertial sensors (4) are provided.

11. The liquid rocket engine impact load structural response prediction method according to claim 1, **characterized in that** in the hot test run process, a rocking amplitude of farthest ends of free ends of the engine is maximum.

## Patentansprüche

1. Verfahren zur Vorhersage der strukturellen Reaktion eines Flüssigkeitsraketenmotors auf Stoßbelastungen,
wobei das Verfahren die folgenden Schritte umfasst:
1) Vereinfachung eines vollständigen Maschinenmodells des Motors,
Erhalten eines vereinfachten vollständigen Maschinenmodells des Motors, indem ein Rahmen (1) eines Motors zu einer Trägerstruktur vereinfacht wird, die zu detektierenden Teile des Motors zu Gehäusestrukturen vereinfacht werden, eine massive Struktur für einen Gaskrümmer (5) des Motors verwendet wird und jede feine Rohrleitung des Motors ignoriert wird, wobei das vereinfachte vollständige Maschinenmodell des Motors den Rahmen (1), den Gaskrümmer (5) und eine Turbopumpe (3), die von oben nach unten nacheinander verbunden sind, wobei ein mittlerer Teil des Gaskrümmers (5) mit dem Rahmen (1) verbunden ist, zwei Enden des Gaskrümmers (5), die jeweils über Schwenklager (2) mit Auslegern gelenkig verbunden sind, und Strahlrohre (4) umfasst, die jeweils an den hinteren Enden der beiden Ausleger angeordnet sind;
2) Erstellen eines Simulationsmodells für die Strukturdynamik des Motors,
Modellieren des vereinfachten vollständigen Maschinenmodells des Motors, um das Simulationsmodell für die Strukturdynamik des Motors zu erhalten, und Verbinden des Rahmenteils (1) des Simulationsmodells mit einem Simulationsmodell für die bewegliche Stütze des Prüfstands;
3) Aufbringen einer Stoßbelastung
Durchführen einer Hochgeschwindigkeitsfotografie in einem realen Motor-Testlaufprozess und Verarbeiten der aus der Fotografie gewonnenen Bilddaten, um Positions- und Lageänderungsdaten der zu detektierenden Teile zu erhalten, wobei die Positions- und Lageänderungsdaten eine zeitabhängige Verschiebungskurve sind und die Kurve Daten von drei Richtungen umfasst: einer axialen Richtung, einer radialen Richtung und einer tangentialen Richtung; und Verwenden der Positions- und Lageänderungsdaten als die Stoßbelastung, die an den entsprechenden Positionen des Simulationsmodells aufgebracht werden soll;
4) Durchführen einer Lösungsberechnung der strukturellen Dynamik der Motorstoßbelastung
nachdem Schritt 3) abgeschlossen ist, Durchführen einer Lösungsberechnung der strukturellen Dynamik für das Simulationsmodell der Motorstoßbelastung; und
5) Analysieren eines Ergebnisses der Lösungsberechnung
unter Verwendung eines in Schritt 4) erhaltenen Ergebnisses der Lösungsberechnung, Analysieren der strukturellen Festigkeit der zu detektierenden Teile des Motors und der Schwenkwinkelcharakteristiken der Schwenklager (2) an den Gelenkpositionen und effektives Bewerten eines strukturellen Grades des Festigkeitssicherheitsbereichs während eines Testlaufs des Motors unter Standard- und Hochleistungsbedingungen gemäß einem Analyseergebnis.

2. Verfahren zur Vorhersage der strukturellen Reaktion eines Flüssigkeitsraketenmotors auf Stoßbelastungen nach Anspruch 1, **dadurch gekennzeichnet, dass** in Schritt 5) das Analysieren der strukturellen Festigkeit der zu detektierenden Teile des Motors und der Schwenkwinkelcharakteristik der Schwenklager (2) an den Gelenkpositionen die folgenden spezifischen Schritte umfasst:
Extrahieren einer zeitabhängigen Kurve der strukturellen Festigkeit der zu erfassenden Teile des Motors aus dem Simulationsmodell, Analysieren einer Größe der maximalen strukturellen Festigkeit und eines Einflusses eines Auftrittszeitpunkts der maximalen strukturellen Festigkeit auf eine Motorstruktur, Extrahieren einer zeitabhängigen Kurve der Schwenkwinkel der Schwenklager (2) und Analysieren von Größen der maximalen Schwenkwinkel und eines Einflusses eines Auftrittszeitpunkts der maximalen Schwenkwinkel auf die Schwenklager (2).

3. Verfahren zur Vorhersage der strukturellen Reaktion eines Flüssigkeitsraketenmotors auf Stoßbelastungen nach Anspruch 1 oder 2, **dadurch gekennzeichnet, dass** während der Modellierung in Schritt 1) die Masse einer entsprechenden Komponente im Simulationsmodell entsprechend der tatsächlichen Masse von jeder Komponente des Motors korrigiert wird, um die Masse der entsprechenden Komponente im Simulationsmodell an die Masse jeder Komponente des Motors anzupassen.

4. Verfahren zur Vorhersage der strukturellen Reaktion eines Flüssigkeitsraketenmotors auf Stoßbelastungen nach Anspruch 3, **dadurch gekennzeichnet, dass** in Schritt 1) die zu detektierenden Teile die Turbopumpe (3) und die beiden Strahlrohre (4) umfassen.

5. Verfahren zur Vorhersage der strukturellen Reaktion eines Flüssigkeitsraketenmotors auf Stoßbelastungen nach Anspruch 4, **dadurch gekennzeichnet, dass** bei der Lösungsberechnung der strukturellen Dynamik der Motorstoßbelastung in Schritt 4) eine festgelegte Dauer zu einem Ausgabeergebnis hinzugefügt wird.

6. Verfahren zur Vorhersage der strukturellen Reaktion eines Flüssigkeitsraketenmotors auf Stoßbelastungen nach Anspruch 5, **dadurch gekennzeichnet, dass** in Schritt 4) die festgelegte Dauer 1 s beträgt.

7. Verfahren zur Vorhersage der strukturellen Reaktion eines Flüssigkeitsraketenmotors auf Stoßbelastungen nach einem der Ansprüche 1 bis 6, **dadurch gekennzeichnet, dass** Schritt 3) auf der Grundlage eines Systems zur Überwachung der strukturellen Ausrichtung eines Raketenmotors mit hoher Schubkraft realisiert wird und das System zur Überwachung der strukturellen Ausrichtung eines Raketenmotors mit hoher Schubkraft reflektierende Markierungspunkte (02), reflektierende Zielkugeln (03), Trägheitssensoren (04), Lasertracker (05), einen Steuerungs-Kollektor (08) und mindestens zwei Hochgeschwindigkeitskameras (06) umfasst;
die Trägheitssensoren (04) an einem anstoßenden Ende eines zu detektierenden Motors (07) und einer anstoßenden Prüfstand-Stütze (01) angeordnet und so konfiguriert sind, dass sie die Bewegungsgeschwindigkeit und Verschiebungsinformationen des anstoßenden Endes des zu detektierenden Motors (07) messen;
die reflektierenden Markierungspunkte (02) an zu detektierenden Teilen des zu detektierenden Motors (07) angeordnet und so konfiguriert sind, dass sie eine Positionsidentifizierung durchführen;
die mindestens zwei Hochgeschwindigkeitskameras (06) beide um den zu detektierenden Motor (07) herum angeordnet und so konfiguriert sind, dass sie einen dreidimensionalen räumlichen Sichtmessbereich des zu detektierenden Motors (07) bilden;
die reflektierenden Zielkugeln (03) auf dem zu detektierenden Motor (07) angeordnet sind und sich in dem Sichtmessbereich der Hochgeschwindigkeitskameras (06) befinden;
die Lasertracker (05) an einer von einem Prüfstand entfernten Position angeordnet und so konfiguriert sind, dass sie eine dreidimensionale dynamische Flugbahn der reflektierenden Zielkugeln (03) in Echtzeit verfolgen;
ein Eingangsende des Steuerungs-Kollektors (08) gleichzeitig mit den Ausgangsenden der Trägheitssensoren (04), der Lasertracker (05) und der Hochgeschwindigkeitskameras (06) verbunden ist; und
Schritt 3) insbesondere die folgenden Schritte umfasst:
3.1) Anstoßen des zu detektierenden Motors (07) an den Prüfstand, gleichzeitiges Auslösen der Hochgeschwindigkeitskameras (06), der Lasertracker (05) und der Trägheitssensoren (04) durch die Vereinheitlichung der Testlaufzeit eines Testlauf-Steuerungsmesssystems und die Erhebung, durch den Steuerungs-Kollektor (08), von Bilddaten eines gesamten Testlaufprozesses, der dreidimensionalen dynamischen Bahn der reflektierenden Zielkugeln (03) und der Bewegungsgeschwindigkeits- und Verschiebungsinformationen des anstoßenden Endes des Motors entsprechend derselben Frequenz;
3.2) Durchführung der Erkennung der reflektierenden Markierungspunkte (02) und der Erkennung der reflektierenden Zielkugeln (03) auf den in Schritt 3.1) erhaltenen Bilddaten Frame für Frame und Bildung von Positions- und Lageinformationen des Motors, welche die eigene zusätzliche Verschiebung der Hochgeschwindigkeitskameras (06) und die Verschiebung der anstoßenden Prüfstand-Stütze (01) gemäß einer Zeitsequenz enthalten;
3.3) Durchführung, unter Verwendung der in Schritt 3.1) erhaltenen dreidimensionalen dynamischen Flugbahn der reflektierenden Zielkugeln (03), eines Frame-für-Frame-Vergleichs von den Positions- und Lageinformationen der reflektierenden Zielkugeln (03) in den in 3.2) erhaltenen Informationen über die Position und Lage des Motors, um die zusätzliche Verschiebung der Hochgeschwindigkeitskameras (06) in den Frame-für-Frame-Bilddaten zu erhalten, und Verwendung der zusätzlichen Verschiebung zur Durchführung einer Ausgleichskorrektur der in Schritt 3.2) erhaltenen Informationen über die Position und Lage des Motors; und
3.4) Korrektur eines in Schritt 3.3) erhaltenen Ergebnisses nach den in Schritt 3.1) erhaltenen Bewegungsgeschwindigkeits- und Verschiebungsinformationen des anstoßenden Endes des Motors, um Positions- und Lageänderungsdaten des Motors relativ zur anstoßenden Stütze (1) für die Bewertung der strukturellen Reaktion des Motors auf Stoßbelastungen zu erhalten.

8. Verfahren zur Vorhersage der strukturellen Reaktion eines Flüssigkeitsraketenmotors auf Stoßbelastungen nach Anspruch 7, **dadurch gekennzeichnet, dass** die Positions- und Lageänderungsdaten in Schritt 3.4) eine zeitabhängige Verschiebungskurve sind und die Kurve Daten in drei Richtungen umfasst: einer axialen Richtung X, einer radialen Richtung Y und einer tangentialen Richtung Z.

9. Verfahren zur Vorhersage der strukturellen Reaktion eines Flüssigkeitsraketenmotors auf Stoßbelastungen nach Anspruch 8, **dadurch gekennzeichnet, dass** eine Vielzahl von reflektierenden Zielkugeln (03) vorgesehen sind und sich mindestens eine reflektierende Zielkugel (03) in dem Sichtmessbereich der Hochgeschwindigkeitskameras (6) angeordnet ist.

10. Verfahren zur Vorhersage der strukturellen Reaktion eines Flüssigkeitsraketenmotors auf Stoßbelastungen nach Anspruch 9, **dadurch gekennzeichnet, dass** die zu detektierenden Teile die Turbopumpe und die beiden Strahlrohre des zu detektierenden Motors (07) sind, zwei Hochgeschwindigkeitskameras (6) vorgesehen sind, die Bildraten beide 1.000 Bilder/s betragen und mehrere Trägheitssensoren (4) vorgesehen sind.

11. Verfahren zur Vorhersage der strukturellen Reaktion eines Flüssigkeitsraketenmotors auf Stoßbelastungen nach Anspruch 1, **dadurch gekennzeichnet, dass** in dem Prozess des Heißtestlaufs die Schwingungsamplitude der äußersten Enden der freien Enden des Motors maximal ist.

## Revendications

1. Procédé de prédiction de réponse structurelle à une charge d'impact d'un moteur de fusée à liquide, le procédé comprenant les étapes consistant à :
1) simplifier un modèle de machine complète de moteur obtenir un modèle simplifié de machine complète de moteur en simplifiant un châssis (1) d'un moteur devant être d'une structure à poutre, en simplifiant les parties à détecter du moteur devant être des structures de logement, en adoptant une structure solide pour un coude de gaz (5) du moteur, et en ne tenant pas compte de chaque conduite fine du moteur, le modèle simplifié de moteur complet comprenant le châssis (1), le coude de gaz (5) et une turbopompe (3) branchée séquentiellement de haut en bas, une partie centrale du coude à gaz (5) étant reliée au châssis (1), deux extrémités du coude à gaz (5) étant articulées avec des bras en porte-à-faux par l'intermédiaire de paliers oscillants (2), respectivement, et des tuyaux de pulvérisation (4) étant disposés aux extrémités arrière des deux bras en porte-à-faux, respectivement ;
2) construire un modèle de simulation de dynamique structurelle de moteur modélisant le modèle simplifié de machine complète de moteur pour obtenir le modèle de simulation de dynamique structurelle de moteur, et connecter la partie châssis (1) du modèle de simulation avec un modèle de simulation de support mobile de banc d'essai ;
3) charger une charge d'impact réalisant une photographie à grande vitesse dans un processus d'essai de moteur réel, et traiter des données d'image obtenues à partir de la photographie pour obtenir des données de changement de position et de pose des parties à détecter, les données de changement de position et de pose étant une courbe de déplacement variant dans le temps, et la courbe comprenant des données de trois directions : une direction axiale, une direction radiale et une direction tangentielle ; et prendre les données de changement de position et de pose comme charge d'impact à charger dans les positions correspondantes du modèle de simulation ;
4) exécuter la résolution de la dynamique structurelle d'impact du moteur une fois que l'étape 3) est terminée, exécuter la résolution de la dynamique structurelle d'impact du modèle de simulation du moteur ; et
5) analyser un résultat de résolution en utilisant un résultat de résolution obtenu à l'étape 4), analyser la résistance structurelle des parties à détecter du moteur et les caractéristiques d'angle de basculement des paliers oscillants (2) à des positions d'articulation, et évaluer efficacement un degré de domaine de sécurité de résistance structurelle pendant l'exécution d'essais en conditions de fonctionnement standard et en conditions de fonctionnement élevées du moteur en fonction d'un résultat d'analyse.

2. Procédé de prédiction de réponse structurelle à une charge d'impact d'un moteur de fusée à liquide selon la revendication 1, **caractérisé en ce que** dans l'étape 5), l'analyse de la résistance structurelle des parties du moteur à détecter et des caractéristiques d'angle de basculement des paliers oscillants (2) aux positions d'articulation comprend les étapes spécifiques consistant à :
extraire du modèle de simulation une courbe variant dans le temps de la résistance structurelle des parties du moteur à détecter, analyser l'amplitude de la résistance structurelle maximale et l'influence d'un moment apparaissant de la résistance structurelle maximale sur une structure du moteur, extraire une courbe variant dans le temps des angles de basculement des paliers oscillants (2), et analyser les dimensions des angles de basculement maximaux et l'influence d'un moment apparaissant des angles de basculement maximaux sur les paliers oscillants (2).

3. Procédé de prédiction de réponse structurelle à une charge d'impact d'un moteur de fusée à liquide selon la revendication 1 ou 2, **caractérisé en ce que**, pendant la modélisation à l'étape 1), la masse d'un composant correspondant dans le modèle de simulation est corrigée en fonction de la masse réelle de chaque composant du moteur, afin que la masse du composant correspondant dans le modèle de simulation soit identique à la masse de chaque composant du moteur.

4. Procédé de prédiction de réponse structurelle à une charge d'impact d'un moteur de fusée à liquide selon la revendication 3, **caractérisé en ce que**, dans l'étape 1), les parties à détecter comprennent la turbopompe (3) et les deux tuyaux de pulvérisation (4).

5. Procédé de prédiction de réponse structurelle à une charge d'impact d'un moteur de fusée à liquide selon la revendication 4, **caractérisé en ce que**, lorsque la résolution de dynamique structurelle d'impact de moteur est effectuée à l'étape 4), une durée établie est ajoutée à un résultat de sortie.

6. Procédé de prédiction de réponse structurelle à une charge d'impact d'un moteur de fusée à liquide selon la revendication 5, **caractérisé en ce que**, dans l'étape 4), la durée établie est de 1 s.

7. Procédé de prédiction de réponse structurelle à une charge d'impact d'un moteur de fusée à liquide selon l'une quelconque des revendications 1 à 6, **caractérisé en ce que** l'étape 3) est réalisée sur la base d'un système de surveillance d'attitude structurelle de moteur de fusée à forte poussée, et que le système de surveillance d'attitude structurelle de moteur de fusée à forte poussée comprend des points de repère réfléchissants (02), des billes cibles réfléchissantes (03), des capteurs inertiels (04), des suiveurs laser (05), un collecteur de commande (08) et au moins deux caméras à grande vitesse (06) ;
les capteurs inertiels (04) sont disposés au niveau d'une extrémité d'aboutement d'un moteur à détecter (07) et d'un support d'aboutement de banc d'essai (01) et configurés pour mesurer la vitesse de déplacement et les informations de déplacement de l'extrémité d'aboutement du moteur à détecter (07) ;
les points de repère réfléchissants (02) sont disposés sur des parties à détecter du moteur à détecter (07), et configurés pour effectuer une identification de position ;
les au moins deux caméras à grande vitesse (06) sont toutes deux disposées autour du moteur à détecter (07) et configurées pour former un domaine de mesure de vision spatiale tridimensionnelle du moteur à détecter (07) ;
les billes cibles réfléchissantes (03) sont disposées sur le moteur à détecter (07) et situées dans le domaine de mesure de vision des caméras à grande vitesse (06) ;
les suiveurs laser (05) sont disposés à une position éloignée d'un banc d'essai et configurés pour suivre une trajectoire dynamique tridimensionnelle des billes cibles réfléchissantes (03) en temps réel ;
une extrémité d'entrée du collecteur de commande (08) est connectée aux extrémités de sortie des capteurs inertiels (04), des suiveurs laser (05) et des caméras à grande vitesse (06) en même temps ; et
l'étape 3) comprend spécifiquement les étapes consistant à :
3.1) abouter le moteur à détecter (07) au banc d'essai, en déclenchant simultanément les caméras à grande vitesse (06), les suiveurs laser (05) et les capteurs inertiels (04) par unification du temps d'exécution d'essai d'un système de mesure de commande d'exécution d'essai, et le collecter, par le collecteur de commande (08), des données d'image d'un processus d'essai complet, de la trajectoire dynamique tridimensionnelle des billes cibles réfléchissantes (03) et des informations de vitesse de déplacement et de déplacement de l'extrémité d'aboutement du moteur selon la même fréquence ;
3.2) effectuer la détection des points de repère réfléchissants (02) et la détection des billes cibles réfléchissantes (03) sur les données d'image obtenues à l'étape 3.1) image par image, et conformer la position du moteur et les informations de pose contenant le propre déplacement supplémentaire des caméras à grande vitesse (06) et le déplacement du support d'aboutement du banc d'essai (01) selon une séquence temporelle ;
3.3) en utilisant la trajectoire dynamique tridimensionnelle des billes cibles réfléchissantes (03) obtenue à l'étape 3.1), en effectuant une comparaison image par image sur les informations de position et de pose des billes cibles réfléchissantes (03) dans la position du moteur et les informations de pose obtenues à l'étape 3.2), afin d'obtenir le déplacement supplémentaire des caméras à grande vitesse (06) dans des données d'image image, image par image, et utiliser le déplacement supplémentaire pour effectuer une correction compensatoire sur la position du moteur et les informations de pose obtenues à l'étape 3.2) ; et
3.4) corriger un résultat obtenu à l'étape 3.3) en fonction des informations de vitesse de déplacement et de déplacement de l'extrémité d'aboutement du moteur obtenues à l'étape 3.1), de manière à obtenir des données de changement de position et de pose du moteur par rapport au support d'aboutement (1) pour l'évaluation de la réponse structurelle à la charge d'impact du moteur.

8. Procédé de prédiction de réponse structurelle à une charge d'impact d'un moteur de fusée à liquide selon la revendication 7, **caractérisé en ce que** les données de changement de position et de pose de l'étape 3.4) sont une courbe de déplacement variant dans le temps, et la courbe comprend des données de trois directions : une direction axiale X, une direction radiale Y et une direction tangentielle Z.

9. Procédé de prédiction de réponse structurelle à une charge d'impact d'un moteur de fusée à liquide selon la revendication 8, **caractérisé en ce qu'**une pluralité de billes cibles réfléchissantes (03) sont prévues, et qu'au moins une bille cible réfléchissante (03) est située dans le domaine de mesure de vision des caméras à grande vitesse (6).

10. Procédé de prédiction de réponse structurelle à une charge d'impact d'un moteur de fusée à liquide selon la revendication 9, **caractérisé en ce que** les parties à détecter sont la turbopompe et les deux tuyaux de pulvérisation du moteur à détecter (07), deux caméras à grande vitesse (6) sont prévues, des cadences d'images sont toutes deux de 1000 images/s, et une pluralité de capteurs inertiels (4) sont prévus.

11. Procédé de prédiction de réponse structurelle à une charge d'impact d'un moteur de fusée à liquide selon la revendication 1, **caractérisé en ce que**, dans le processus d'exécution d'essai à chaud, une amplitude de basculement des extrémités les plus éloignées des extrémités libres du moteur est maximale.
